# EUROPEAN PATENT APPLICATION

(11) **EP 2 826 804 A1**
(43) Date of publication of application: **21.01.2015**
(21) Application number: 12871574.5
(22) Date of filing: 12.03.2012
(51) Int. Cl.: C08G 61/12, H01L 51/00

(54) **POLYMER CONTAINING THIOPHENE-BENZENE-THIOPHENE UNIT, PREPARATION METHOD THEREFOR AND SOLAR CELL DEVICE**

(71) Applicant: Ocean's King Lighting Science&Technology Co., Ltd., Guangdong 518054 (CN); Shenzhen Ocean's King Lighting Engineering Co. Ltd, Shenzhen, Guangdong (CN)
(72) Inventor: ZHOU, Mingjie, Shenzhen Guangdong 518054 (CN); WANG, Ping, Shenzhen Guangdong 518054 (CN); ZHANG, Zhenhua, Shenzhen Guangdong 518054 (CN); HUANG, Hui, Shenzhen Guangdong 518054 (CN)
(74) Representative: Michalski, Stefan
(86) International application number: PCT/CN2012/072218
(87) International publication number: WO 2013/134915

(57) **Abstract**

A polymer containing thiophene-benzene-thiophene unit has the following formula as (I): 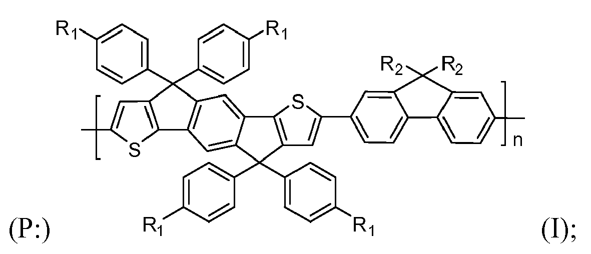 R₁ represents C₁ to C₂₀ alkyl, R₂ represents C₁ to C₂₀ alkyl, *n* is an integer from 10 to 100. An energy gap of the polymer containing thiophene-benzene-thiophene unit is narrow, and therefore the power conversion efficiency is improved greatly. A method of preparing the polymer containing thiophene-benzene-thiophene unit and a sorlar cell device using the polymer containing thiophene-benzene-thiophene unit are also provided.

## Description

### FIELD OF THE INVENTION

The present disclosure relates to an optoelectronic field, more particularly relates to a polymer containing thiophene-benzene-thiophene unit, preparation method thereof and solar cell device using the polymer containing thiophene-benzene-thiophene unit.

### BACKGROUND OF THE INVENTION

Energy issues are the serious concern of all countries in the world. Solar energy is the best alternative energy for mankind in the future, how to convert solar energy into electrical power is a hotspot in research. In recent years, the popular conjugated polymer thin film organic solar cells have advantages of low cost, light weight, simple fabrication process, capable of being prepared into flexible devices, etc.. In addition, many kinds of organic materials can be used as the material of the thin film organic solar cells, and the thin film organic solar cells have great designability; it is promising to improve the performance of the organic solar cells through the design and optimization of materials.

In the polymer containing thiophene-benzene-thiophene unit, the thiophene is a typical electron-deficient unit, thus the polymer containing thiophene-benzene-thiophene unit has high hole mobility and shows an excellent photovoltaic performance. However, the band gap (the energy difference between the HOMO level and the LUMO level) of the conventional band gap of the polymers containing thiophene-benzene-thiophene unit is relatively wide, which reduces the absorptivity to the photon in the solar spectrum, so that the power conversion efficiency of the solar cell having the polymer containing thiophene-benzene-thiophene unit is low.

### SUMMARY OF THE INVENTION

Accordingly, it is necessary to provide a polymer containing thiophene-benzene-thiophene unit having high power conversion efficiency.

In addition, it is necessary to provide a method of preparing a polymer containing thiophene-benzene-thiophene unit.

In addition, it is necessary to provide a solar cell device having a polymer containing thiophene-benzene-thiophene unit.

A polymer containing thiophene-benzene-thiophene unit has a formula:

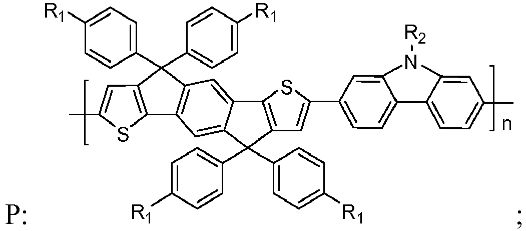

where R₁ represents C₁ to C₂₀ alkyl, R₂ represents C₁ to C₂₀ alkyl, *n* is an integer from 10 to 100.

A method of preparing a polymer containing thiophene-benzene-thiophene unit includes the steps of:
compounds A and B represented by the following formulas are provided: 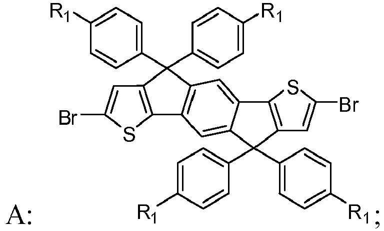 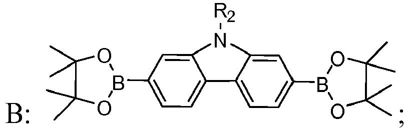 where R₁ represents C₁ to C₂₀ alkyl, R₂ represents C₁ to C₂₀ alkyl; and
in an oxygen-free environment, the compound A and the compound B according to a molar ratio of 1:1 to 1:1.2 are added to an organic solvent containing a catalyst; and a Suzuki coupling reaction is performed; where the catalyst is organic palladium or a mixture of organic palladium and organic phosphine ligand; then the polymer containing thiophene-benzene-thiophene unit P is obtained: 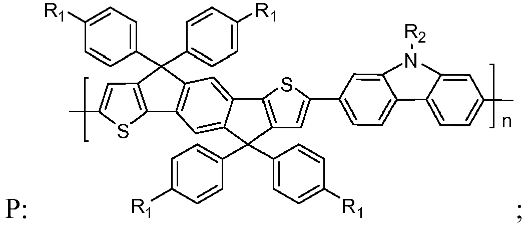 where *n* is an integer from 10 to 100.

Preferably, the organic solvent is at least one selected from the group consisting of toluene, N, N-dimethylformamide, and tetrahydrofuran.

Preferably, the organic palladium is selected from the group consisting of bis(triphenylphosphine) palladium(II) dichloride, tetrakis(triphenylphosphine)palladium, and tris(dibenzylideneacetone) dipalladium; the organic phosphine ligand is selected from the group consisting of tri-tert-butylphosphine and 2-dicyclohexylphosphino -2',6'-dimethoxybiphenyl; a molar ratio between the organic palladium and the organic phosphine ligand is 1:4 to 1:8.

Preferably, a molar ratio between the organic palladium in the catalyst and the compound A is 1:20 to 1:100.

Preferably, a reaction temperature of the Suzuki coupling reaction is 70°C to 130°C, a reaction time is 12 to 96 hours.

Preferably, a reaction temperature of the Suzuki coupling reaction is 80°C to 110°C.

Preferably, the method further includes purifying the polymer containing thiophene-benzene-thiophene unit P, where the step of purifying includes the steps of:
methanol is added to a reaction solution obtained by the Suzuki coupling reaction of the compound A and the compound B for precipitating and then filtering;
a solid obtained from the filtering is extracted with methanol and n-hexane successively;
the extracted solid is further extracted with chloroform; and
the chloroform solution is collected and the solvent is evaporated to obtain a purified polymer containing thiophene-benzene-thiophene unit P.

Preferably, a Soxhlet extractor is used for the extracting.

A solar cell device includes an active layer, where the active layer is made of a polymer containing thiophene-benzene-thiophene unit P having the following formula: 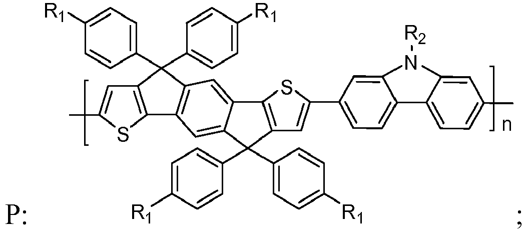 where R₁ represents C₁ to C₂₀ alkyl, R₂ represents C₁ to C₂₀ alkyl, *n* is an integer from 10 to 100.

In the polymer containing thiophene-benzene-thiophene unit, the thiophene-benzene-thiophene (TPT) derivative has characteristics of high hole mobility, narrow band gap, high absorption coefficient to the sunlight, and wide absorption range; and carbazole has high hole mobility, excellent chemical stability, and photophysical properties easily modified, thus when the polymer containing thiophene-benzene-thiophene unit and carbazole unit is applied to the solar cell device, the power conversion efficiency can be greatly improved.

### BRIEF DESCRIPTION OF THE DRAWINGS

FIG. 1 is a flow chart of a method of preparing the polymer containing thiophene-benzene-thiophene unit according to an embodiment;
FIG. 2 is a schematic, cross-sectional view of a solar cell device according to an embodiment; and
FIG. 3 shows a UV-visible absorption spectrum of the polymer containing thiophene-benzene-thiophene unit of Example 1.

### DETAILED DESCRIPTION OF THE EMBODIMENTS

A more detailed description of the polymer containing thiophene-benzene-thiophene unit and a preparation method thereof and an application thereof will be illustrated by reference to specific embodiments and drawings.

A polymer containing thiophene-benzene-thiophene unit of an embodiment has the following formula: 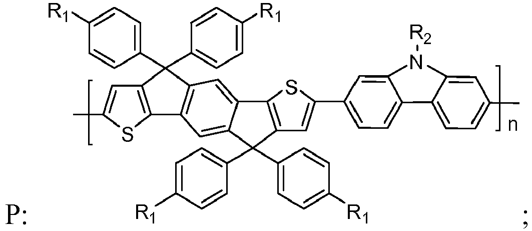 where R₁ represents C₁ to C₂₀ alkyl, R₂ represents C₁ to C₂₀ alkyl, *n* is an integer from 10 to 100.

In the polymer containing thiophene-benzene-thiophene unit, the thiophene-benzene-thiophene (TPT) derivative has characteristics of high hole mobility, narrow band gap, high absorptivity to the sunlight, and wide absorption range; carbazole has high hole mobility, excellent chemical stability, and its photophysical properties are easily modified, thus when the polymer containing thiophene-benzene-thiophene unit and carbazole is applied to the solar cell device, the power conversion efficiency can be greatly improved.

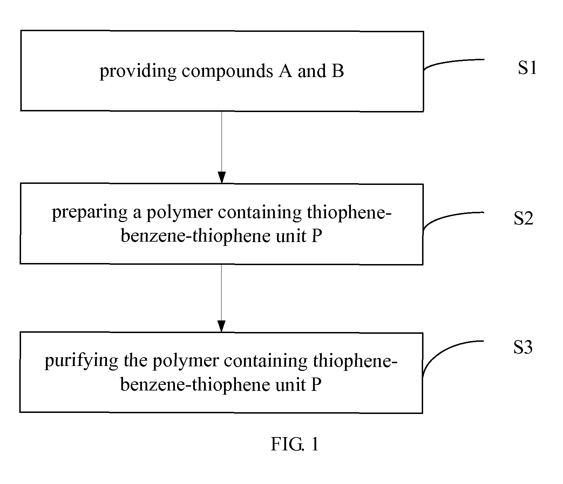

Referring to FIG. 1, an embodiment of a method of preparing the polymer containing thiophene-benzene-thiophene unit includes the following steps of:

### Step S1, compounds A and B are provided.

The formula of the compound A is 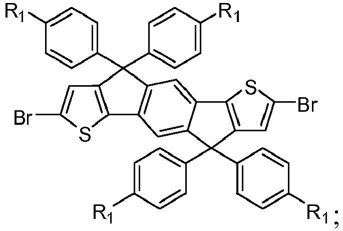 where R₁ represents C₁ to C₂₀ alkyl.

The formula of the compound B is 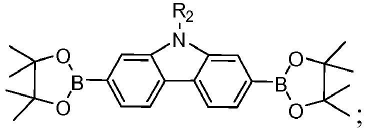 where R₂ represents C₁ to C₂₀ alkyl.

In the illustrated embodiment, the compound A can be synthesized according to the method disclosed in the reference of *Macromolecule, 2008, 41, 5519* or purchased from the market. The compound B can be synthesized according to the method disclosed in the reference of *Macromolecule, 2008, 41, 6012* or purchased from the market.

### Step S2, the polymer containing thiophene-benzene-thiophene unit P is prepared.

In an oxygen-free environment, the compound A and the compound B according to a molar ratio of 1:1 to 1:1.2 are added to an organic solvent containing a catalyst to perform a Suzuki coupling reaction. The catalyst is organic palladium or a mixture of organic palladium and organic phosphine ligand, then the polymer containing thiophene-benzene-thiophene unit P is obtained: 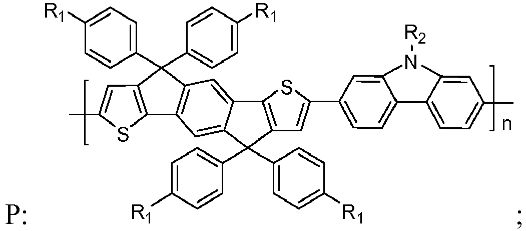 where R₁ represents C₁ to C₂₀ alkyl, R₂ represents C₁ to C₂₀ alkyl, *n* is an integer from 10 to 100.

In the illustrated embodiment, the Suzuki coupling reaction is performed under nitrogen atmosphere.

In the illustrated embodiment, the organic solvent is at least one selected from the group consisting of toluene, N, N-dimethylformamide, and tetrahydrofuran. It should be understood that the organic solution can also be other solvents, as long as it can dissolve the compound A and compound B.

In the illustrated embodiment, the organic palladium is selected from the group consisting of bis(triphenylphosphine) palladium(II) dichloride, tetrakis(triphenylphosphine) palladium, and tris(dibenzylideneacetone) dipalladium. The organic phosphine ligand is selected from the group consisting of tri-tert-butylphosphine and 2-dicyclohexylphosphino-2',6'-dimethoxybiphenyl. A molar ratio between the organic palladium and the organic phosphine ligand in the mixture of the organic palladium and the organic phosphine ligand is 1:4 to 1:8. Preferably, the catalyst is a mixture of tris(dibenzylideneacetone) dipalladium and tri-tert-butylphosphine. It should be understood that the organic palladium and the organic phosphine ligand are not limited to the types as listed, as long as the compound A and compound B can perform the Suzuki coupling reaction catalyzed by the catalyst.

In the illustrated embodiment, a molar ratio between the organic palladium in the catalyst and the compound A is 1:20 to 1:100. It should be understood that the molar ratio between the organic palladium and the compound A is not limited to 1:20 to 1:100, as long as a catalytic amount of the catalyst is added to the organic solvent of the compound A and compound B.

In the illustrated embodiment, a reaction temperature of the Suzuki coupling reaction is 70°C to 130°C, a reaction time is 12 to 96 hours. Preferably, the reaction temperature of the Suzuki coupling reaction is 80°C to 110°C, the reaction time is 24 to 72 hours. It should be understood that the reaction temperature is not limited to 70°C to 130°C, as long as the compound A and compound B can react; the reaction time is not limited to 12 to 96 hours, as long as the reaction of compound A and compound B is completed.

### Step S3, the polymer containing thiophene-benzene-thiophene unit P is purified.

Methanol is added to a reaction solution obtained by the Suzuki coupling reaction of the compound A and the compound B for precipitating and then the solution is filtered. A solid obtained from the filtering is extracted with methanol and n-hexane successively, then the solid is extracted with chloroform; and the chloroform solution is collected and the solvent is evaporated to obtain a purified polymer containing thiophene-benzene-thiophene unit P.

In the illustrated embodiment, a Soxhlet extractor is used for the extracting.

In the illustrated embodiment, after the chloroform solution is collected and the solvent is evaporated, the obtained purified polymer containing thiophene-benzene-thiophene unit P is dried at a temperature of 50°C for 24 hours.

The synthetic route of the method of preparing the polymer containing thiophene-benzene-thiophene unit is comparatively simple, the manufacturing cost is reduced. The prepared polymer containing thiophene-benzene-thiophene unit has high hole mobility and narrow band gap.

The specific examples are shown as follows.

### EXAMPLE 1

This example disclosed a poly {bis (4,4 - bis (4 - n-octyl-phenyl) - indeno[1,2-b]thiophene)-co-N-n-octyl carbazole} (polymer containing thiophene-benzene-thiophene unit P1) with the following formula:

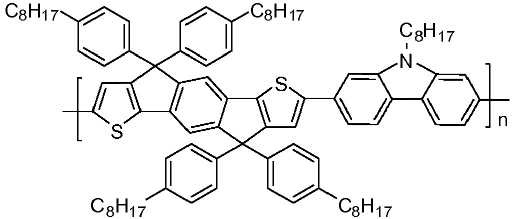

The preparation process of the polymer containing thiophene-benzene-thiophene unit P1 was shown as follow:
Under the protection of nitrogen, bis (2 - bromo -4,4 - bis (4 - n-octyl-phenyl)- indeno [1,2-b] thiophene (353mg, 0.3mmol), N-n-octyl-2,7-bis(4,4,5,5-tetramethyl-1,3,2-dioxaborolan-2-yl)-9H-carbazole ( 159mg, 0.015mmol ), tris(dibenzylideneacetone)dipalladium (13.75mg, 0.015mmol), and tri-tert-butylphosphine ( 24.2mg, 0.12mmol ) were dissolved in 12ml of toluene, and a potassium carbonate solution (3 mL, 2mol/L) was added to the solution, then nitrogen was sufficiently introduced to exhaust the air for approximately 30 minutes, the reaction lasted for 48 hours at a temperature of 95°C in the condition of stirring. The polymerization reaction stopped after cooling. 40mL of methanol was added to flask, the reaction solution was precipitated to obtain sediment. The sediment was extracted with methanol and n-hexane successively for 24 hours by a Soxhlet extractor after filtering. The sediment was then extracted by using chloroform as a solvent until the reaction solution was colorless. A chloroform solution was collected and rotary evaporated to obtain a red powder, and finally the red powder was dried under vacuum at a temperature of 50°C for 24 hours to obtain a product with a yield of 75%.

The reaction of the prepared polymer containing thiophene-benzene-thiophene unit P1 was shown as follows:

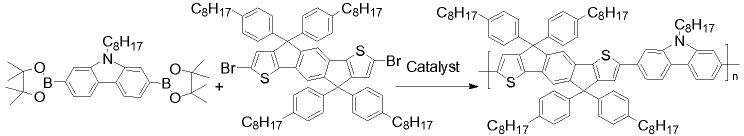

Test results of molecular weight were: Molecular weight (GPC, THF, R.I): *Mₙ* =72.6kDa, *M_{w}*/*Mₙ* = 2.2.

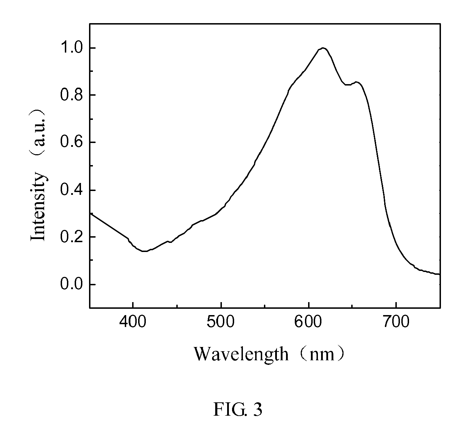

Referring to FIG. 3, the poly {bis (4,4 - bis (4 - n-octyl-phenyl) - indeno[1,2-b]thiophene) -co-N-n-octyl carbazole} of Example 1 was tested by UV-visible absorption spectra. The results shown that the conjugated polymer had a wide absorption between 400∼750nm, the maximum absorption peak was at about 616nm.

### EXAMPLE 2

This example disclosed a poly {bis (4,4 - bis (4 - methylphenyl) - indeno [1,2-b] thiophene-co-N- n-eicosyl carbazole} (polymer containing thiophene-benzene-thiophene unit P2) with the following formula:

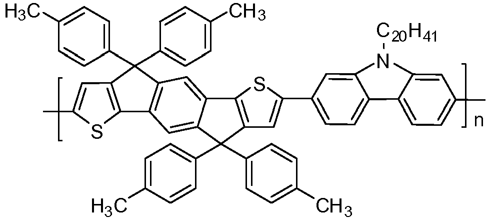

The preparation process of the polymer containing thiophene-benzene-thiophene unit P2 was shown as follow:
Under the protection of nitrogen, bis (2 - bromo -4,4 - bis (4 - methylphenyl) - indeno [1,2-b] thiophene) (157 mg, 0.2mmol), N-n-eicosyl-2,7-bis(4,4,5,5-tetramethyl-1,3,2-dioxaborolan-2-yl)-9H-carbazole (153.8mg, 0.22mmol), and 15ml of N, N-dimethylformamide were added to a flask, and a potassium carbonate solution (2mL, 2mol/L) was added to the solution; then the flask was evacuated to remove the oxygen and the nitrogen was sufficiently introduced to the flask, then bis(triphenylphosphine) palladium(II) dichloride (5.6mg,0.008mmol) was added, the solution was heated to 120°C to react for 36 hours; the mixed solution was dropped to 50ml of methanol for precipitation after cooling to room temperature. Sediment was obtained; the sediment was extracted with methanol and n-hexane successively for 24 hours by a Soxhlet extractor after filtering. The sediment was then extracted by using chloroform as a solvent until the reaction solution was colorless. A chloroform solution was collected and rotary evaporated to obtain a red powder, and finally the red powder was filtrated under vacuum for overnight to obtain a product with a yield of 66%.

The reaction of the prepared polymer containing thiophene-benzene-thiophene unit P2 was shown as follows:

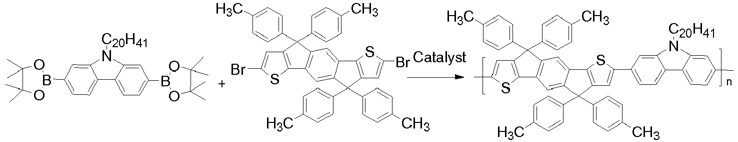

Test results of molecular weight were: Molecular weight (GPC, THF, R.I): *Mₙ* =53.9kDa, *M_{w}*/*Mₙ* =2.3.

The poly {bis (4,4 - bis (4 - methylphenyl) - indeno [1,2-b] thiophene-co-N-n-eicosyl carbazole} of Example 2 was tested by UV-visible absorption spectra. The results shown that the conjugated polymer had a wide absorption between 400∼750nm, the maximum absorption peak was at about 619nm.

### EXAMPLE 3

This example disclosed a poly {bis (4,4- bis (4 - n-eicosyl alkylphenyl) - indeno [1,2-b] thiophene-co-N- methyl-carbazole} (polymer containing thiophene-benzene-thiophene unit P3) with the following formula:

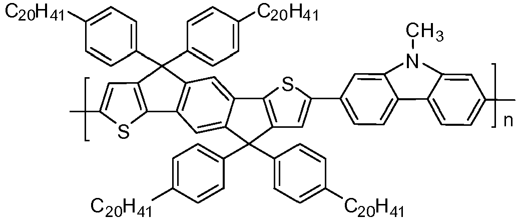

The preparation process of the polymer containing thiophene-benzene-thiophene unit P3 was shown as follow:
Under the protection of nitrogen, bis (2 - bromo -4,4 - bis (4 - n-eicosyl alkylphenyl) - indeno [1,2-b] thiophene) (555 mg, 0.3 mmol), N-methyl -2,7-bis(4,4,5,5-tetramethyl-1,3,2-dioxaborolan-2-yl)-9H- carbazole (155.9 mg, 0.36 mmol), and 15ml of tetrahydrofuran were added to a 50mL of 2-necked flask, respectively; nitrogen was sufficiently introduced to exhaust the air for approximately 20 minutes; then tetrakis(triphenylphosphine)palladium ( 4 mg, 0.003mmol ) was added, and a potassium carbonate solution (3mL, 2mol/L) was added to the solution, then nitrogen was sufficiently introduced to exhaust the air for approximately 10 minutes, the reaction lasted for 96 hours at a temperature of 70°C in the condition of stirring. The polymerization reaction stopped after cooling. 40mL of methanol was added to the flask, the reaction solution was precipitated to obtain sediment; the sediment was extracted with methanol and n-hexane successively for 24 hours by a Soxhlet extractor after filtering. The sediment was then extracted by using chloroform as a solvent until the reaction solution was colorless. A chloroform solution was collected and rotary evaporated to obtain a red powder, and finally the red powder was dried under vacuum at a temperature of 50°C for 24 hours to obtain a product with a yield of 84%.

The reaction of the prepared polymer containing thiophene-benzene-thiophene unit P3 was shown as follows:

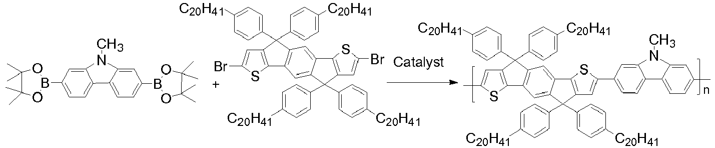

Test results of molecular weight were: Molecular weight (GPC, THF, R.I): *Mn* =88.7kDa, *M_{w}*/*Mₙ* =2.1.

The poly {bis (4,4- bis (4 - n-eicosyl alkylphenyl) - indeno [1,2-b] thiophene-co -N- methyl-carbazole} of Example 3 was tested by UV-visible absorption spectra. The results shown that the conjugated polymer had a wide absorption between 400∼750 nm, the maximum absorption peak was at about 618nm.

### EXAMPLE 4

This example disclosed a poly {bis (4,4 - bis (4 - n-butyl phenyl) - indeno [1,2 - b] thiophene-co-N-n-decyl carbazole} (polymer containing thiophene-benzene-thiophene unit P4) with the following formula:

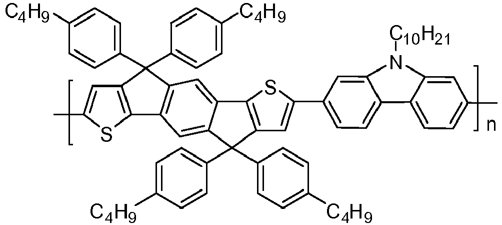

The preparation process of the polymer containing thiophene-benzene-thiophene unit P4 was shown as follow:
Under the protection of nitrogen, bis (2 - bromo -4,4 - bis (4 - 4 - n-butyl phenyl) - indeno [1,2-b] thiophene) (157 mg, 0.2mmol), N-n-decyl-2,7-bis(4,4,5,5-tetramethyl-1,3,2-dioxaborolan-2-yl)-9H-carbazole (143.8 mg, 0.24 mmol), and 15ml of N, N-dimethylformamide were added to a flask; and a potassium carbonate solution (2mL, 2mol/L) was added to the solution; then the flask was evacuated to remove the oxygen and the nitrogen was introduced, then bis(triphenylphosphine) palladium(II) dichloride (7.2mg, 0.01mmol) was added, the solution was heated to 130°C to react for 24 hours. The mixed solution was dropped to 50ml of methanol for precipitation after cooling to room temperature. Sediment was obtained; the sediment was extracted with methanol and n-hexane successively for 24 hours by a Soxhlet extractor after filtering. The sediment was then extracted by using chloroform as a solvent until the reaction solution was colorless. A chloroform solution was collected and rotary evaporated to obtain a red powder, and finally the red powder was filtrated under vacuum for overnight to obtain a product with a yield of 76%.

The reaction of the prepared polymer containing thiophene-benzene-thiophene unit P4 was shown as follows:

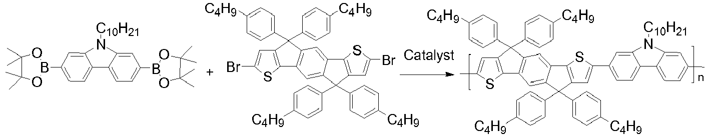

Test results of molecular weight were: Molecular weight (GPC, THF, R.I):*Mₙ* =48.5kDa, *M_{w}*/*Mₙ* =2.4.

The poly {bis (4,4 - bis (4 - n-butyl phenyl) - indeno [1,2 - b] thiophene-co-N-n-decyl carbazole} of Example 4 was tested by UV-visible absorption spectra. The results shown that the conjugated polymer has a wide absorption between 400∼750nm, the maximum absorption peak was at about 614nm.

### EXAMPLE 5

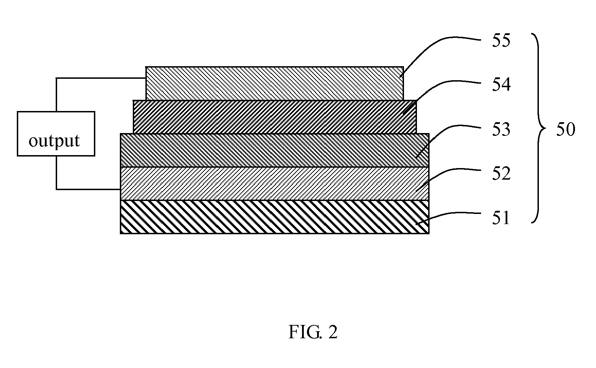

Referring to FIG. 2, a solar cell device 50 includes a substrate 51, an anode 52, a buffer layer 53, an active layer 54, and a cathode 55. The anode 52, the buffer layer 53, the active layer 54, and the cathode 55 are sequentially formed on the substrate 51.

In the illustrated embodiment, the substrate 51 is made of glass.

The anode 52 is formed on a side of the substrate 51. In the illustrated embodiment, the anode 52 is made of ITO (indium tin oxide). Preferably, the ITO has a sheet resistance of 10 to 20Ω/sq. The buffer layer 53 is formed on a side of the anode 52 away from the substrate 51. The buffer layer 53 is made of a composite of poly 3, 4-ethylenedioxythiophene and poly styrene sulfonate (PEDOT: PSS).

The active layer 54 is formed on a side of the buffer layer 53 away from the anode 52. The active layer 54 includes an electron donor material and an electron acceptor material. A molar ratio of the electron donor material and the electron acceptor material is 1:2. The electron acceptor material can be [6, 6] - phenyl - C₆₁ - butyric acid methyl ester (PCBM). The electron donor material is the polymer containing thiophene-benzene-thiophene unit P. In the illustrated embodiment, the electron donor material is poly {bis (4,4 - bis (4 - n-octyl-phenyl) - indeno[1,2-b]thiophene)-co-9,9 - di-n-octyl carbazole} obtained from the Example 1.

The cathode 55 is formed on a side of the active layer 54 away from the buffer layer 53. The cathode 55 can be an aluminum electrode or a double-layer metal electrode, such as Ca/Al or Ba/Al and so on; the thickness of the cathode 55 is preferably 150nm, 35nm, 120mm, or 70nm. In the illustrated embodiment, the cathode 55 is made of aluminum, and the thickness of the cathode 55 is 150nm.

It can be understood that, the buffer layer 53 can be omitted, and then the active layer 54 is formed directly on the surface of the anode 52.

The manufacturing processes of the solar cell device 50 are shown as follows:

The anode 52 was formed on a side of the substrate 51; then cleaned by ultrasonic and treated with an oxygen-Plasma; then the anode 52 was spin-coated with a layer of PEDOT: PSS for modification to form the buffer layer 53.

The active layer 54 was coated on the buffer layer 53. The active layer 54 included an electron donor material and an electron acceptor material. The electron acceptor material was PCBM. The electron donor material was the poly {bis (4,4-bis(4-n-octyl-phenyl)- indeno [1,2-b] thiophene)-co- N-n-octyl carbazole} obtained from the Example 1.

The cathode 55 was deposited on the active layer 54. In the illustrated embodiment, the cathode 55 was an aluminum layer formed by vacuum deposition. The thickness of the cathode 55 was 150nm.

In the illustrated embodiment, the solar cell device 50 was heated at 110°C for 4 hours in a sealed condition, and then cooled to room temperature. The anneal of the solar cell device can effectively increase the arranged orderliness and regularity of each group in the molecule and the molecular chain segments, and the carrier mobility and the efficiency of the transmission speed were improved, thereby improving the photoelectric conversion efficiency.

Under the AM1.5G 100mW/cm² illumination, the power conversion efficiency of the bulk-heterojunction solar cell device 50 using the polymer of Example 1 as the electron donor material is 4.1 %,

When the solar cell device 50 is in use, under illumination, the light is transmitted through the substrate 51 and the anode 52; then the light energy is absorbed by the hole-conduction type electroluminescent material of the active layer 54, thus generating excitons. The excitons migrate to the interface between the electron donor and acceptor materials, and the electrons are transferred to the electron acceptor material, such as PCBM, the charges are separated, thereby forming the free carriers, i.e. the free electrons and the holes. The free electrons are transferred to the cathode 55 along the electron acceptor material and collected by the cathode; the free holes are transferred to the anode 52 along the electron donor material and collected by the node 52, thereby forming the photocurrent and photovoltage, and the photoelectric conversion is implemented. When a load is connected, the device is capable of supplying power. Since the hole-conduction type electroluminescent material has a wide spectral response range, the light energy is fully utilized to gain much higher photoelectric conversion efficiency, and the power generation capacity of the organic solar cell is increased. Moreover, this type of organic material is also capable of reducing the weight of the organic solar cell; and it can be made by spin coating and other technologies for mass production.

Although the invention has been described in language specific to structural features and/or methodological acts, it is to be understood that the invention defined in the appended claims is not necessarily limited to the specific features or acts described. Rather, the specific features and acts are disclosed as sample forms of implementing the claimed invention.

## Claims

1. A polymer containing thiophene-benzene-thiophene unit, having a formula: 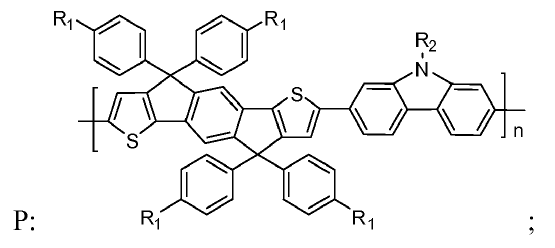 wherein R₁ represents C₁ to C₂₀ alkyl, R₂ represents C₁ to C₂₀ alkyl, *n* is an integer from 10 to 100.

2. A method of preparing a polymer containing thiophene-benzene-thiophene unit, comprising the steps of:
providing compounds A and B represented by the following formulas: 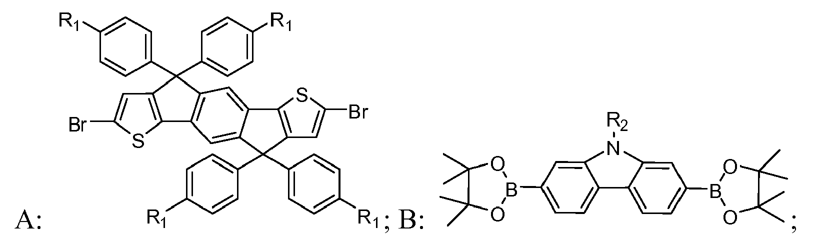 wherein R₁ represents C₁ to C₂₀ alkyl, R₂ represents C₁ to C₂₀ alkyl; and adding, in an oxygen-free environment, the compound A and the compound B according to a molar ratio of 1:1 to 1:1.2 to an organic solvent containing a catalyst; and performing a Suzuki coupling reaction; wherein the catalyst is organic palladium or a mixture of organic palladium and organic phosphine ligand; then obtaining the polymer containing thiophene-benzene-thiophene unit P: 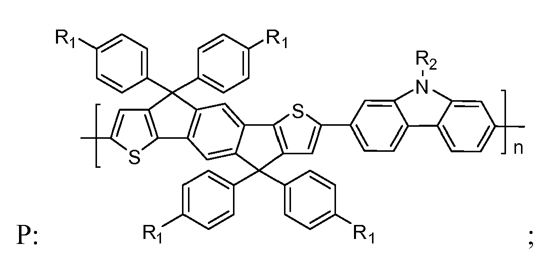 wherein *n* is an integer from 10 to 100.

3. The method of preparing a polymer containing thiophene-benzene-thiophene unit according to claim 2, wherein the organic solvent is at least one selected from the group consisting of toluene, N, N-dimethylformamide, and tetrahydrofuran.

4. The method of preparing a polymer containing thiophene-benzene-thiophene unit according to claim 2, wherein the organic palladium is selected from the group consisting of bis(triphenylphosphine) palladium(II) dichloride, tetrakis(triphenylphosphine)palladium, and tris(dibenzylideneacetone)dipalladium; the organic phosphine ligand is selected from the group consisting of tri-tert-butylphosphine and 2-dicyclohexylphosphino-2',6'-dimethoxybiphenyl; a molar ratio between the organic palladium and the organic phosphine ligand is 1:4 to 1:8.

5. The method of preparing a polymer containing thiophene-benzene-thiophene unit according to claim 2, wherein a molar ratio between the organic palladium in the catalyst and the compound A is 1:20 to 1:100.

6. The method of preparing a polymer containing thiophene-benzene-thiophene unit according to claim 2, wherein a reaction temperature of the Suzuki coupling reaction is 70°C to 130°C, a reaction time is 12 to 96 hours.

7. The method of preparing a polymer containing thiophene-benzene-thiophene unit according to claim 2, wherein a reaction temperature of the Suzuki coupling reaction is 80°C to 110°C.

8. The method of preparing a polymer containing thiophene-benzene-thiophene unit according to claim 2, further comprising:
purifying the polymer containing thiophene-benzene-thiophene unit P, wherein the step of purifying comprises the steps of:
adding methanol to a reaction solution obtained by the Suzuki coupling reaction of the compound A and the compound B for precipitating and then filtering;
extracting a solid obtained from the filtering with methanol and n-hexane successively;
extracting the extracted solid with chloroform; and
collecting the chloroform solution and evaporating the solvent to obtain a purified polymer containing thiophene-benzene-thiophene unit P.

9. The method of preparing a polymer containing thiophene-benzene-thiophene unit according to claim 8, wherein a Soxhlet extractor is used for the extracting.

10. A solar cell device, comprising an active layer, wherein the active layer is made of a polymer containing thiophene-benzene-thiophene unit P having the following formula: 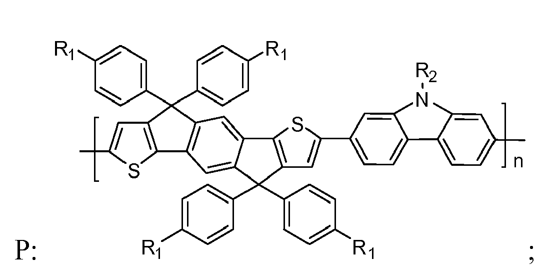 wherein R₁ represents C₁ to C₂₀ alkyl, R₂ represents C₁ to C₂₀ alkyl, *n* is an integer from 10 to 100.
